# EUROPEAN PATENT APPLICATION

(11) **EP 2 770 538 A1**
(43) Date of publication of application: **27.08.2014**
(21) Application number: 13156607.7
(22) Date of filing: 25.02.2013
(51) Int. Cl.: H01L 29/861, H01L 27/02, H01L 29/87, H01L 29/06, H01L 21/20, H01L 21/329

(54) **Fin type semiconductor structure suitable for producing esd protection device**

(71) Applicant: IMEC, 3001 Leuven (BE); Taiwan Semiconductor Manufacturing Company, Ltd. (TSMC), Hsinchu 300-077 (TW)
(72) Inventor: Linten, Dimitri, 3001 LEUVEN (BE); Chen, Shih-Hung, 3001 LEUVEN (BE); Hellings, Geert, 3001 LEUVEN (BE); Song, Ming-Hsiang, 3001 LEUVEN (BE)
(74) Representative: Pronovem

(57) **Abstract**

A semiconductor structure suitable for producing an Electrostatic Discharge (ESD) protection device, the structure comprising a plurality of fins on a substrate region of a first doping type. The fins have a base portion of said same first doping type (e.g. n-type), with at least one fin having a top portion of a second doping type (e.g. p-type), so that a p-n junction extends over the entire length of said at least one fin. The plurality of fins comprises a number of a p-fins and a number of n-fins, arranged in alternating fashion or in separate groups of p and n fins, preferably with a larger distance between the groups than between neighbouring fins in the group. The structure can be applied in the production of any known type of ESD protection device, facilitating the production of such devices in a fin-based technology.

## Description

### Field of the Invention

The present invention is related to the fabrication of semiconductor structures, applicable in an ESD protection device.

### State of the art.

In semiconductor processing, structures comprising p-n junctions between oppositely doped regions in a semiconductor substrate are essential for the construction of ESD (Electrostatic Discharge) protection devices. There is an ongoing need for improving the process efficiency of these devices and for integrating the production of said structures into standard semiconductor processing technology, especially in the area of fin-type processing.

### Summary of the invention

The invention is related to structures, devices and production methods as described in the appended claims, which answer to the above-described need. The present invention is related to a semiconductor structure suitable for producing an Electrostatic Discharge (ESD) protection device, the structure comprising a plurality of fins on a substrate region of a first doping type. The fins have a base portion of said same first doping type (e.g. n-type), with at least one fin having a top portion of a second doping type (e.g. p-type), so that a p-n junction extends over the entire length of said at least one fin. According to preferred embodiments, the plurality of fins comprises a number of a p-fins and a number of n-fins, arranged in alternating fashion or in separate groups of p and n fins, preferably with a larger distance between the groups than between neighbouring fins in the group. The structure can be applied in the production of any known type of ESD protection device, facilitating the production of such devices in a fin-based technology. The invention is equally related to ESD devices as such comprising the structure of the invention and to methods for producing the structure.

The invention is in particular related to a semiconductor structure comprising :
- A base substrate consisting of doped semiconductor material of a first doping type,
- A plurality of mutually parallel fins on said base substrate, each of said fins consisting of a base portion and a top portion, said portions extending over the entire length of the fin,
- dielectric material in the regions between each pair of neighbouring fins,
   wherein :
   - said base portions consist of doped semiconductor material of said first doping type,
   - the top portion of at least one of said fins consists of semiconductor material of a second doping type opposite to the first, forming a p-n junction with the base portion of said fin,
   - the top portions of the remaining fins consist of semiconductor material of said first doping type.

In the structure of the invention, said fins may have alternating top portions of the first and second doping type.

According to another embodiment, said fins are grouped in one or more first groups of fins having a top portion of the first doping type and one or more second groups of fins having a top portion of the second doping type. In a particular embodiment, the distance between two groups of fins having top portions of opposite doping types may be larger than the distance between two individual fins in each of said groups.

The invention is equally related to a semiconductor device comprising :
- a semiconductor structure according to the invention,
- first contact means for contacting all the fins having a top portion of the first doping type, and second contact means for contacting all the fins having a top portion of the second doping type.

In a device according to the invention, said first and second contact means may comprise metal-filled contact vias and metal lines separated by intermetal dielectric material. A separating layer may be present, covering the top and at least part of the side surfaces of said top portions of the fins, in the areas between said contact vias said separating layer comprising at least a dielectric layer in contact with said top and side surfaces.

The device of the invention may be a diode. The device of the invention may be an Electrostatic Discharge protection device.

The invention is equally related to a method for producing a semiconductor structure comprising the steps of :
- Providing a semiconductor substrate,
- By Shallow Trench Isolation, producing a plurality of mutually parallel fins separated by a dielectric,
- Before or after said STI step, performing a first doping step to obtain a first doping level of a first doping type in said fins and in a bulk area of the substrate underneath said fins,
- Performing a second doping step, so as to obtain a second level of said first doping type in a top portion of one or more of said fins, the second level being higher than the first level,
- Performing a third doping step so as to obtain a third level of a second doping type opposite the first type, in a top portion of the remaining fins, the third level being higher than the first level.

According to an embodiment, said second and third doping steps are performed so as to obtain alternating top portions of the first and second doping type.

According to another embodiment, said second and third doping steps are performed so as to obtain one or more first groups of fins having a top portion of the first doping type and one or more second groups of fins having a top portion of the second doping type. According to a particular embodiment of the method, the distance between two groups of fins having top portions of opposite doping types is larger than the distance between two individual fins in each of said groups.

The invention is equally related to a method for producing a semiconductor device, comprising the steps of :
- Providing a semiconductor structure according to the invention,
- Producing first contact means for contacting all the fins having a top portion of the first doping type, and second contact means for contacting all the fins having a top portion of the second doping type.

According to an embodiment of the method for producing a device according to the invention, said first and second contact means comprise metal-filled contact vias and metal lines separated by intermetal dielectric material. The latter embodiment may further comprise the step of producing a separating layer, said layer covering the top and at least part of the side surfaces of said top portions of the fins, in the areas between said contact vias, said separating layer comprising at least a dielectric layer in contact with said top and side surfaces.

### Brief description of the figures

Figure 1 illustrates a schematic image of a diode structure according to the invention comprising two fins. In reality the structure is likely to comprise more than two fins.

Figure 2 shows a 3D-image of a diode according to the invention comprising multiple fins, including a contact structure obtainable by standard BEOL techniques.

Figure 3 shows an embodiment comprising multiple fins grouped together in groups of p and n-type fins respectively.

Figures 4a to 4g illustrate a method for producing a structure according to the invention.

Figure 5 illustrates an SCR type device for ESD protection, incorporating semiconductor structures according to the invention.

### Detailed description of the invention

Definition : in the present description, a 'diode structure' is defined as a semiconductor structure suitable for producing a diode by electrically connecting said structure to a cathode and anode terminal. The diode structure is thus basically a structure comprising a p-n junction between oppositely doped regions, and suitable for being contacted so that a current may run through said junction depending on the external voltage between cathode and anode. The invention is not limited to diodes as such. The diode structure may be contacted in other ways than the way described above, or may be part of a larger device, such as various types of ESD protection devices, see further.

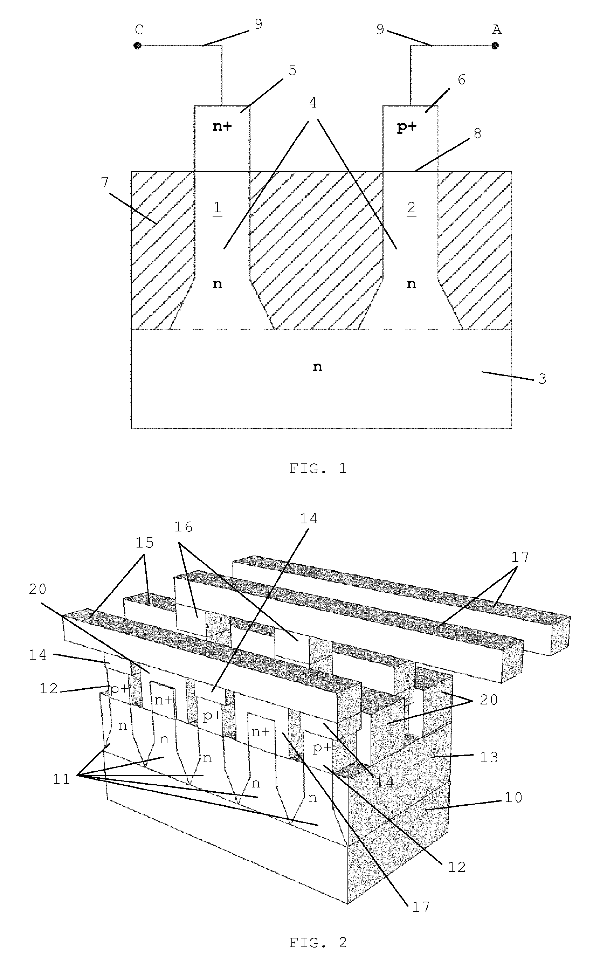

As shown in figure 1, a diode structure according to the invention comprises at least two mutually parallel fin-shaped structures 1 and 2 (hereafter referred to as 'fins'), placed on a common base substrate 3. The base substrate consists of a semiconductor material of a first doping type, for example n-doped silicon in the embodiment shown in figure 1. The base substrate 3 can be a portion of a larger substrate, e.g. an n-well in a p-doped silicon wafer. The fins have a base portion 4 and top portions 5 and 6. The base portions are n-doped, like the base substrate 3. Preferably, the base portions are integral with the base substrate, i.e. forming one solid body of the same n-doped material. In the embodiment of figure 1, the top portions 5 and 6 of the fins are respectively n+ doped and p+ doped (the '+' indicating high dopant density). The fins are embedded in a layer 7 of dielectric material, for example SiO₂, with at least part of the top portions 5/6 extending outwards with respect to said layer 7. According to a preferred embodiment, the dopant density for region 4 (n in figure 1 or p if the doping types are reversed with respect to the embodiment of figure 1) is between 1e16cm⁻³ and 2e18cm⁻³, more preferably between 1e17cm⁻³ and 5e17cm⁻³. The dopant density for the n+ and p+ regions 5 and 6 may be between 5e19cm⁻³ and 5e21cm⁻³, more preferably between 2e20cm⁻³ and 6e20cm⁻³.

Characteristically for the invention, each base portion 4 and each top portion 5/6 of the fins is doped by the same dopant type over its entire length (i.e. perpendicular to the drawing of figure 1). Hence the p-n junction 8 in the second fin 2, which defines the diode when the structure is connected to cathode and anode terminals C and A, is a horizontal junction between a top portion 6 that is p+ doped and a base portion 4 that is n-doped. As in planar diodes, the n+ top portion 5 is required for obtaining a good ohmic contact for the charge carriers towards the contacts on top of the fins. Said contacts are shown only schematically by contact lines 9 leading to cathode and anode terminals C and A respectively (a more realistic version of the contact lines is shown hereafter). The top level of the dielectric layer 7 does not necessarily coincide with the position of the junction 8. The doping types described above and indicated in figure 1 may be reversed (p instead of n and n instead of p).

According to a preferred embodiment, a diode structure according to the invention comprises more than two fins. A structure of this type is shown in figure 2, which is a 3-D picture of a diode according to the invention, including a metallization structure for contacting the diode. Five fins are shown on an n-type base substrate 10, each having an n-doped base portion 11 and alternately provided with p+ and n+ doped top portions 12. The base portions 11 are embedded in a dielectric layer 13, e.g. a silicon oxide. Metal-filled vias 14 are provided on top of the p+ top portions 12, and interconnected by metal lines 15. Further metal-filled vias 16 are provided on top of the n+ top portions 12 and interconnected by higher level metal lines 17. The vias and metal lines are separated from each other by intermetal dielectric layers (not shown), and can be produced according to known metallization techniques, known as BEOL (Back-end-of-line) processing.

In the embodiment of figure 2, separating layers 20 are present in between the contact vias 14 on the p+ fins and in between contact vias 16 on the n+ fins. These layers 20 are formed of a dielectric material or at least comprise a dielectric material in contact with the fins. For example, the layers 20 could have the structure of a gate stack : a dielectric layer covered by a metal layer, the dielectric isolating the fin from the metal. The layers 20 are covering the top and side surface of the fins' top portions 12, both the n+ and the p+ type top portions 12. The reason for these layers 20 is to avoid shorting neighbouring top portions 12 of different doping types when these top portions are subjected to Selective Epitaxial Growth (SEG). SEG is a known technique applied to source and drain areas of FinFET transistors in order to decrease the resistance of these areas. SEG consists basically in growing a semiconductor layer on the top portion 12 of the fins, growing outward from the side walls and top surface of said top portions. Although not shown in figure 2, SEG is preferably applied on the fins of a diode structure according to the invention. The outward growth of the SEG material may cause neighbouring p+ and n+ fins to be shorted, which may be prevented by the layers 20. The layers 20 are shaped like gates of a finFET device, and may thus be produced by available processes for gate definition and processing.

The layers 20 are an optional feature that can be applied as a way of avoiding the shorting of p+ and n+ fins in a structure according to the invention. Another way of avoiding the shorting of p+ and n+ fins is by putting them at a greater distance from each other, as illustrated by the embodiment of figure 1 as compared to figure 2. The distance should be high enough to avoid contact between SEG-grown material on neighbouring fins.

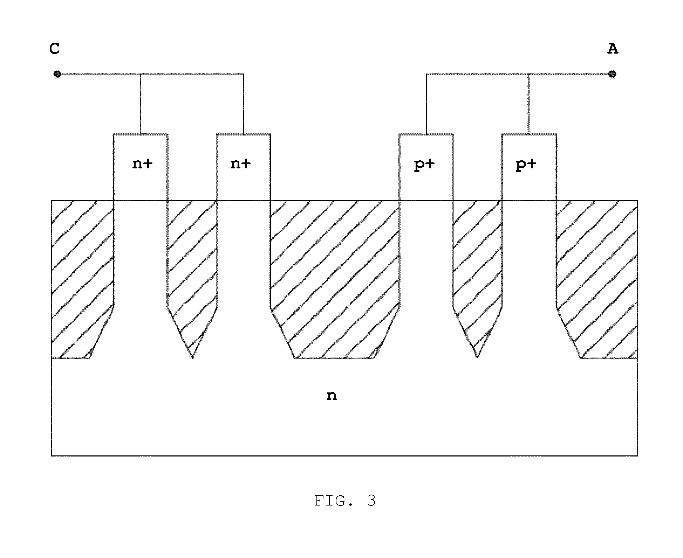

Instead of alternating p+ and n+ fins as in the embodiment of figure 2, groups of n+ fins and p+ fins may be produced, as illustrated by the embodiment shown in figure 3. In the latter embodiment, the distance between the group of n+ fins and the group of p+ fins is higher than the distance between individual fins in each group. This is again for reasons of avoiding shorting as a consequence of SEG. The advantage of grouping together a number of fins of the same doping type is that no precautions must be taken against shorting by SEG in the space between two neighbouring fins in a single group.

Another embodiment (not shown) has groups of p+ and n+ fins with no difference in the distance between the fins of each group and between two neighbouring groups, but with a gate-shaped separation layer 20 in between the groups for avoiding shorting by SEG. This embodiment and the one with alternating doping types for all fins as shown in figure 2 has the advantage that it allows to produce a maximum of fins on a particular wafer surface.

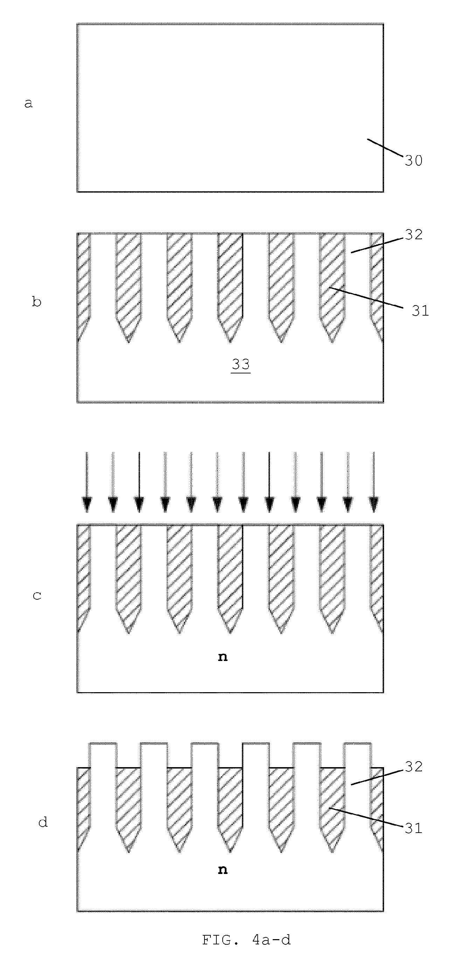

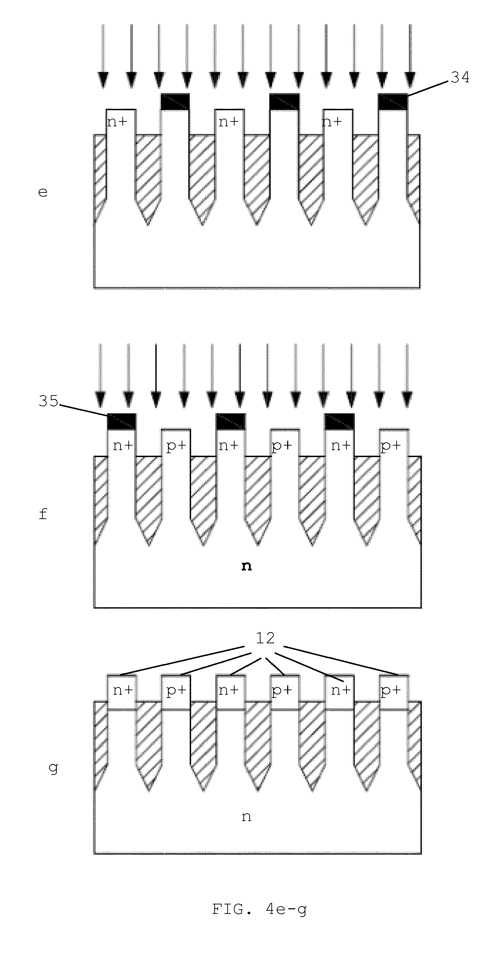

Figure 4 illustrates a possible process for producing a diode structure according to the invention. The process starts from an undoped or lowly doped substrate 30, e.g. a silicon wafer, see figure 4a. A number of trenches filled with silicon oxide 31 are produced by a standard STI (Shallow Trench Isolation) technique, known as such in the art (see figure 4b). The silicon structures in between the trenches are the fins 32 which are uniform with the bulk area 33.

A first doping step is then performed, to create a first n-type doping level in the fins 32 and in the bulk area 33 underneath said fins, see figure 4c.

Alternatively, the first doping step may be performed before the STI step. According to a preferred embodiment, the dopant density for obtained in the first doping step (n or p) is between 1e16cm⁻³ and 2e18cm⁻³, more preferably between 1e17cm⁻³ and 5e17cm⁻³.

A top portion of the oxide is then removed by a known etching technique while covering the fins by a mask (not shown), leading to the structure of figure 4d.

This is followed by a second doping step performed under circumstances for obtaining a higher dopant density than the first doping step wherein an n-type dopant is injected into a first group of fins, while the other fins are covered by a first mask 34. This leads to the top portions of said first group being n-doped at a higher doping level (n+) than the doping level of the fins and bulk area (fig. 4e).

After removing the first mask 34, a third doping step is done by injecting p-type dopants into the remaining group of fins, while covering the first group by a mask 35. The third doping step is again performed under circumstances for obtaining a higher dopant density than the first doping step. This leads to the top portions of said remaining group being p-doped at a high doping level (p+) (fig. 4f). The order of the n+ and p+ implant steps may be reversed. The dopant density for the n+ and p+ regions obtained after the second and third doping steps may be between 5e19cm⁻³ and 5e21cm⁻³, more preferably between 2e20cm⁻³ and 6e20cm⁻³.

After removing the second mask 35, the structure is obtained as shown in figure 4g, comprising the top portions 12 of alternating p+ and n+ type. Standard SEG and BEOL steps (not shown) are then performed for creating the metal vias and contact lines 14/16/15/17 shown in figure 2. Optionally, the layer 20 may be applied on top of the top portions 12 of the fins, before subjecting the fins to the standard SEG process.

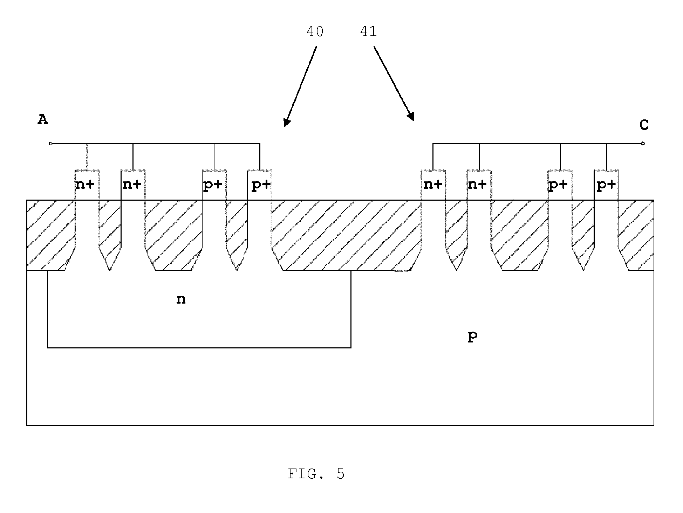

The diode structure of the invention may be applied in various ESD device structures. In any known planar embodiment of ESD protection devices, such as Silicon Controlled rectifier (SCR) or Bipolar Junction Transistor (BJT), the planar structures may be replaced by fin-based structures according to the invention. An example of this is shown in figure 5, which shows a standard SCR device, produced with 2 diode structures 40 and 41 according to the invention. Any other existing SCR architecture or other ESD device may be produced in an analogue way.

While the invention has been illustrated and described in detail in the drawings and foregoing description, such illustration and description are to be considered illustrative or exemplary and not restrictive. Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

The foregoing description details certain embodiments of the invention. It will be appreciated, however, that no matter how detailed the foregoing appears in text, the invention may be practiced in many ways, and is therefore not limited to the embodiments disclosed. It should be noted that the use of particular terminology when describing certain features or aspects of the invention should not be taken to imply that the terminology is being re-defined herein to be restricted to include any specific characteristics of the features or aspects of the invention with which that terminology is associated.

Unless specifically specified, the description of a layer being deposited or produced 'on' another layer or substrate, includes the options of
- said layer being produced or deposited directly on, i.e. in contact with, said other layer or substrate, and
- said layer being produced on one or a stack of intermediate layers between said layer and said other layer or substrate.

## Claims

1. A semiconductor structure comprising :
- A base substrate (3) consisting of doped semiconductor material of a first doping type,
- A plurality of mutually parallel fins (1,2) on said base substrate, each of said fins consisting of a base portion (4,13) and a top portion (5,6,12), said portions extending over the entire length of the fin,
- dielectric material (7) in the regions between each pair of neighbouring fins,
wherein :
• said base portions (4) consist of doped semiconductor material of said first doping type,
• the top portion (6,12) of at least one of said fins consists of semiconductor material of a second doping type opposite to the first, forming a p-n junction with the base portion (4) of said fin,
• the top portions (5,12) of the remaining fins consist of semiconductor material of said first doping type.

2. Semiconductor structure according to claim 1, wherein said fins have alternating top portions (5,6,12) of the first and second doping type.

3. Semiconductor structure according to claim 1, wherein said fins are grouped in one or more first groups of fins having a top portion (6,12) of the first doping type and one or more second groups of fins having a top portion (5,12) of the second doping type.

4. Semiconductor structure according to claim 3, wherein the distance between two groups of fins having top portions of opposite doping types is larger than the distance between two individual fins in each of said groups.

5. A semiconductor device comprising :
- a semiconductor structure according to any one of the preceding claims,
- first contact means (9,14,15) for contacting all the fins having a top portion of the first doping type, and second contact means (9,16,17) for contacting all the fins having a top portion of the second doping type.

6. Device according to claim 5, wherein said first and second contact means comprise metal-filled contact vias (14,16) and metal lines (15,17) separated by intermetal dielectric material.

7. Device according to claim 6, wherein a separating layer (20) covers the top and at least part of the side surfaces of said top portions of the fins, in the areas between said contact vias (14,16), said separating layer comprising at least a dielectric layer in contact with said top and side surfaces.

8. Device according to any one of claims 5 to 7, wherein said device is a diode.

9. Device according to any one of claims 5 to 7, wherein said device is an Electrostatic Discharge protection device.

10. Method for producing a semiconductor structure comprising the steps of :
- Providing a semiconductor substrate (30),
- By Shallow Trench Isolation, producing a plurality of mutually parallel fins (32) separated by a dielectric (31),
- Before or after said STI step, performing a first doping step to obtain a first doping level of a first doping type in said fins (32) and in a bulk area (33) of the substrate (30) underneath said fins,
- Performing a second doping step, so as to obtain a second level of said first doping type in a top portion of one or more of said fins, the second level being higher than the first level,
- Performing a third doping step so as to obtain a third level of a second doping type opposite the first type, in a top portion of the remaining fins, the third level being higher than the first level.

11. Method according to claim 10, wherein said second and third doping steps are performed so as to obtain alternating top portions (12) of the first and second doping type.

12. Method according to claim 10, wherein said second and third doping steps are performed so as to obtain one or more first groups of fins having a top portion (12) of the first doping type and one or more second groups of fins having a top portion (12) of the second doping type.

13. Method for producing a semiconductor device, comprising the steps of :
- Providing a semiconductor structure according to any one of claims 1 to 9,
- Producing first contact means (9,14,15) for contacting all the fins having a top portion of the first doping type, and second contact means (9,16,17) for contacting all the fins having a top portion of the second doping type.

14. Method according to claim 13, wherein said first and second contact means comprise metal-filled contact vias (14,16) and metal lines (15,17) separated by intermetal dielectric material.

15. Method according to claim 14, further comprising the step of producing a separating layer (20), said layer covering the top and at least part of the side surfaces of said top portions of the fins, in the areas between said contact vias (14,16), said separating layer comprising at least a dielectric layer in contact with said top and side surfaces.
